# EUROPÄISCHE PATENTSCHRIFT

(11) **EP 2 396 826 B1**
(45) Veröffentlichungstag und Bekanntmachung des Hinweises auf die Patenterteilung: **05.08.2015**
(21) Anmeldenummer: 10703795.4
(22) Anmeldetag: 11.01.2010
(51) Int. Cl.: H01L 31/05

(54) **SOLARZELLENSTRING UND SOLARMODUL MIT DERARTIGEN SOLARZELLENSTRINGS**
SOLAR CELL STRING AND SOLAR MODULE HAVING SUCH SOLAR CELL STRINGS
CHAÎNE DE CELLULES SOLAIRES ET MODULE SOLAIRE AVEC DES TELLES CHAÎNES DE CELLULES SOLAIRES

(30) Priorität: 16.02.2009 DE 102009003491
(43) Veröffentlichungstag der Anmeldung: 21.12.2011
(73) Patentinhaber: Hanwha Q CELLS GmbH, 06766 Bitterfeld-Wolfen (DE)
(72) Erfinder: PFENNIG, Andreas, 04129 Leipzig (DE)
(74) Vertreter: Bakhtyari, Arash
(86) Internationale Anmeldenummer: PCT/DE2010/075003
(87) Internationale Veröffentlichungsnummer: WO 2010/091680

(56) Entgegenhaltungen:
- EP-A1- 1 981 088
- EP-A1- 1 981 090
- WO-A1-2005/098969
- WO-A1-2009/019929
- WO-A2-2009/011791
- DE-A1- 19 715 138
- JP-A- 2008 140 920

## Beschreibung

Die vorliegende Erfindung betrifft einen Solarzellenstring, der eine Mehrzahl miteinander elektrisch verschalteter Solarzellen umfasst. Ferner betrifft die vorliegende Erfindung ein Solarmodul, das aus erfindungsgemäßen Solarstrings aufgebaut ist.

Anders als bei Dünnschicht-Solarmodulen, bei deren Herstellung sich eine monolithische Verschaltung der einzelnen Solarzellen zu einem Solarmodul realisieren lässt, sind Wafer-Solarzellen üblicherweise in einem hybriden Aufbau über Zellverbinder, beispielsweise in Form von Lötbändchen, elektrisch miteinander verschaltet. Eine Mehrzahl derart miteinander verschalteter Solarzellen bezeichnet man üblicherweise als Solarzellenstring, wobei mehrere nebeneinander angeordnete Strings zur Bildung eines Solarmoduls elektrisch miteinander gekoppelt sind.

Ein solcher Solarzellenstring umfasst eine Solarzelle, gebildet aus einem Wafersubstrat mit einem flächigen Elektroden-Kontaktabschnitt, beispielsweise in Form einer Busbar, eine benachbart zur Solarzelle angeordnete weitere Solarzelle, gebildet aus einem weiteren Wafersubstrat mit einem flächigen weiteren Elektroden-Kontaktabschnitt und mindestens einen sich entlang einer Erstreckungsrichtung vom Elektroden-Kontaktabschnitt der Solarzelle zum weiteren Elektroden-Kontaktabschnitt der weiteren Solarzelle erstreckenden bandförmigen Zellverbinder. Dieser bandförmige Zellverbinder weist eine Zellverbinderbreite und eine im Wesentlichen senkrecht zu den Elektroden-Kontaktabschnitten orientierten Zellverbinderdicke auf, wobei der Zellverbinder Elektroden der Solarzelle mit weiteren Elektroden der weiteren Solarzelle elektrisch miteinander verschaltet.

Zur Einsparung kostspieligen Halbleitermaterials z.B. in Form von Silizium werden Solarzellen auf immer dünneren Wafersubstraten hergestellt. Substratdicken von deutlich weniger als 500 µm, wie zum Beispiel 300 µm und 160 µm sind inzwischen üblich. Diese Solarzellen-Substrate werden mechanisch immer fragiler. Für die hybride Verschaltung mittels bandförmiger Zellverbinder in Form von Lotbändchen bringt der Lötvorgang eine signifikante mechanische Belastung mit sich. Diese Lötbändchen sind beispielsweise als Kupferbändchen ausgebildet, die mit einem Weichlot oder mit einer gut lötbaren Metallisierungsschicht überzogen sind. Die thermischen Ausdehnungskoeffizienten der metallischen Lötbändchen sind im Vergleich zum Silizium derart unterschiedlich, dass nach dem Lötvorgang beim Abkühlen entstehende mechanische Spannungen zu einer mit dem Auge erkennbaren Verbiegung der Wafer bzw. auch zum Bruch der Wafer führen können. Um diese mechanischen Spannungen gering zu halten, kommen Lötbändchen zum Einsatz, die Ihrerseits eine Dicke aufweisen, die kleiner oder gleich der zum Einsatz kommenden Waferdicke ist. Mit immer dünneren Lötbändchen steigt jedoch deren ohmscher Widerstand. Ein Ausgleich der sinkenden Leitfähigkeit durch eine Erhöhung der Lötbändchen-Breite ist nur beschränkt möglich, da ein signifikanter Überlapp der Lötbändchen über die Breite der auf den Solarzellen kontaktierten Busbars hinaus zu zusätzlichen Abschattungen der Lichteinfallszonen auf der Solarzelle führte. Dies würde jedoch zu einer unerwünschten Herabsetzung des Solarzellen-Wirkungsgrades führen.

WO05098969A1 offenbart einen Solarzellenstring aus miteinander elektrisch verbundenen Solarzellen. Die Solarzellen sind beidseitig kontaktiert und die elektrische Verbindung erfolgt über bandförmige Zellverbinder jeweils von einer Vorderseite einer Solarzelle zu einer Rückseite einer Nachbarsolarzelle. In einigen Ausführungsformen sind die Zellverbinder in zwischen den Solarzellen angeordneten Verbinderbereichen dicker ausgestaltet, als auf den Solarzellen-Vorderseiten und Solarzellen-Rückseiten.

Unterschiedliche Ausgestaltungen von Zellverbindern sowie Verfahren zur Zusammenschaltung von Solarzellen zu Solarzellenstrings mit derartigen Zellverbindern, finden sich in EP01981090A1. Die darin beschriebenen Zellverbinder weisen seitliche Ausnehmungen auf, welche den Zellverbindern Flexibilität verleihen, um thermische Ausdehnungen und Verbiegungen der mittels ihrer verschalteten Solarzellen auszugleichen.

Der vorliegenden Erfindung liegt die Aufgabe zu Grunde, einen Solarzellenstring bereitzustellen, der die Verwendung dünner Wafer-Solarzellen ermöglicht, wobei der Wirkungsgrad dieser Solarzellen durch die elektrische Kontaktierung mit Zellverbindern möglichst wenig beeinflusst werden soll.

Erfindungsgemäß ist vorgesehen, dass die Zellverbinderdicke des bandförmigen Zellverbinders entlang seiner Erstreckungsrichtung ausgehend von der Solarzelle in Richtung der weiteren Solarzelle betrachtet zumindest abschnittsweise zunimmt.

Mit der Zunahme der Dicke des Zellverbinders steigen die vom Wafersubstrat aufzunehmenden mechanischen Spannungen. Gleichzeitig sinkt der ohmsche Widerstand des Zellverbinders. Dadurch, dass die Zunahme der Dicke nicht entlang des gesamten Zellverbinders sondern abschnittsweise vorliegt, ist die Zunahme der entstehenden mechanischen Spannungen beschränkt. Gleichzeitig sinkt der serielle Widerstand des Zellverbinders.

Bevorzugt nimmt die Zellverbinderdicke in Stromflussrichtung der Solarzelle zu. Dies bringt den Vorteil mit sich, dass dem anwachsenden elektrischen Stroms mehr Leiterfläche zur Verfügung steht.

Geeignete Wertebereiche für die Zunahme der Zellverbinderdicke des bandförmigen Zellverbinders stellen Faktoren von 1,5 bis 3, bevorzugt ein Faktor 2 dar. Diese Bereiche führen bereits zu einer signifikanten Steigerung des Wirkungsgrades der Solarzellen des Strings, ohne zu viel mechanische Spannungen einzubringen.

Bevorzugt sind der Elektroden-Kontaktabschnitt und / oder der weitere Elektroden-Kontaktabschnitt als Busbar mit einer Busbar-Breite ausgebildet. Die Busbars sind üblicherweise als in das Wafersubstrat eingebrannte Metallkontakte ausgebildet. Für frontseitenkontaktierte Wafersolarzellen liegen übliche Busbar-Breiten bei etwa 2 mm, wenn zwei Busbars vorgesehen sind. Bei drei Busbars kommen Busbar-Breiten von etwa 1,5 mm zum Einsatz.

Mit Vorteil ist die Zellverbinderbreite des Zellverbinders im Wesentlichen kleiner oder gleich der Busbar-Breite ausgebildet. Dadurch lässt sich der bandförmige Zellverbinder derart auf den Busbars anordnen, dass der Zellverbinder ausschließlich mit den Busbars der Solarzellen überlappt. Dadurch ist sicher gestellt, dass eine Minderung des Solarzellenwirkungsgrades durch die Abschattung von Teilen der Lichteintrittsfläche der Solarzellen durch die bandförmigen Zellverbinder auftritt. Die Auswahl der Zellverbinderbreite hängt stark von der im jeweiligen Montageprozess zur Verfügung stehenden Positioniergenauigkeit des Zellverbinders ab. Außerdem können schmale Zellverbinder dazu neigen, herstellungsbedingt eine leicht säbelförmige Kontur anzunehmen. Eine derartig geschwungene Kontur macht es bei geradlinigen Busbars schwierig, dass die Zellverbinder ausschließlich auf den Busbars zu liegen kommen.

In der vorliegenden Erfindung umfasst der bandförmige Zellverbinder in Richtung der Zellverbinderdicke betrachtet eine Mehrzahl übereinander angeordneter bandförmiger Verbinderelemente, die sich entlang der Erstreckungsrichtung auf einem Überlappabschnitt der Solarzelle und entlang eines weiteren Überlappabschnitts der weiteren Solarzelle abschnittsweise überlagern.

Weiterhin ist es vorteilhaft, wenn die bandförmigen Verbinderelemente jeweils eine Dicke aufweisen, die kleiner oder gleich der Wafersubstrat-Dicke ist. Durch diese Beschränkung ist die nach einem Lötvorgang durch die einzelnen Verbinderelemente eingetragene mechanische Spannung in einem ausreichenden Maße begrenzt. Dadurch wird übermäßige Verbiegung oder gar der Bruch des Wafersubstrates verhindert. Weiterhin weisen derart dünne bandförmige Verbinderelemente in Form von Lötbändchen eine geringere Wärmekapazität auf, so dass entsprechend geringere Wärmeenergiemengen beim Lötvorgang eingetragen werden müssen.

Für die Ausführungsform des aus Verbinderelementen aufgebauten bandförmigen Zellverbinders ist bevorzugt vorgesehen, dass der Überlappabschnitt und der weitere Überlappabschnitt benachbart zueinander auf den Solarzellen angeordnet sind und jeweils 10 bis 80%, bevorzugt 25 bis 35% der Erstreckungslänge der jeweiligen Elektroden-Kontaktabschnitte einnehmen. Über die spezifische Auswahl der Länge lässt sich der Betrag auftretender mechanischer Spannungen beeinflussen und für die jeweiligen Randbedingungen optimieren.

Die Solarzellen sind bei allen Ausführungsformen als frontseitenkontaktierte Solarzellen mit Lichteintrittsseiten ausgebildet, wobei die Lichteintrittsseiten eine Mehrzahl Elektroden-Kontaktabschnitte in Form von Busbars aufweist, die jeweils mit einem bandförmigen Zellverbinder versehen sind. Die Zellverbinder des Solarzellenstrings verlaufen dann bei einer Serienverschaltung von Solarzellen in bekannter Weise von den Frontseiten der Solarzellen zu den Rückseiten der benachbarten Solarzellen.

Beim Einsatz frontseitenkontaktierter Zellen ist es möglich, dass in der Aufsicht auf die Lichteintrittsseiten der Solarzelle die Mehrzahl der bandförmigen Verbinderelemente ein in Richtung der weiteren Solarzelle versetzt angeordnetes unteres bandförmiges Verbinderelement aufweist, das unter einem entlang des Elektroden-Kontaktabschnittes der Solarzelle angeordneten oberen Verbinderelement angeordnet ist. Auf diese Weise ist der modulare Aufbau der bandförmigen Zellverbinder aus einer Mehrzahl bandförmiger Verbinderelemente von der Lichteinfallsseite her betrachtet nicht zu erkennen. Dadurch ergibt sich im Hinblick auf die optische Anmutung des Solarzellenstrings ein harmonischeres Gesamtbild. Es ist selbstverständlich möglich, unterschiedliche bandförmige Verbinderelemente miteinander zu kombinieren. Wie bereits erwähnt können bandförmige Verbinderelemente ein Kupferband aufweisen, das mit Weichlot und/oder einer lötbaren Metallbeschichtung versehen ist. Ebenso ist denkbar, verschiedene Arten von Weichlot einzusetzen.

Die beschriebenen Solarzellenstrings sind besonders geeignet, um für die Herstellung von Solarmodulen verbaut zu werden. Dazu ist eine Mehrzahl miteinander verschalteter Solarzellenstrings in bekannter Weise wetterfest zu einem Modul verkapselt.

Weitere Merkmale und Eigenschaften der Erfindung werden im Zusammenhang mit den Ausführungen zu einer in den nachfolgenden Figuren gezeigten konkreten Ausführungsform näher erläutert.

Es zeigen:
- Figur 1: eine schematische, nicht maßstabsgetreue Seitenansicht eines Solarzellenstrings;
- Figur 2: eine Sicht auf den Solarzellenstring entlang der in Figur 1 dargestellten Pfeile II; und
- Figur 3: eine Sicht auf den Solarzellenstring entlang der in Figur 1 dargestellten Pfeile III.

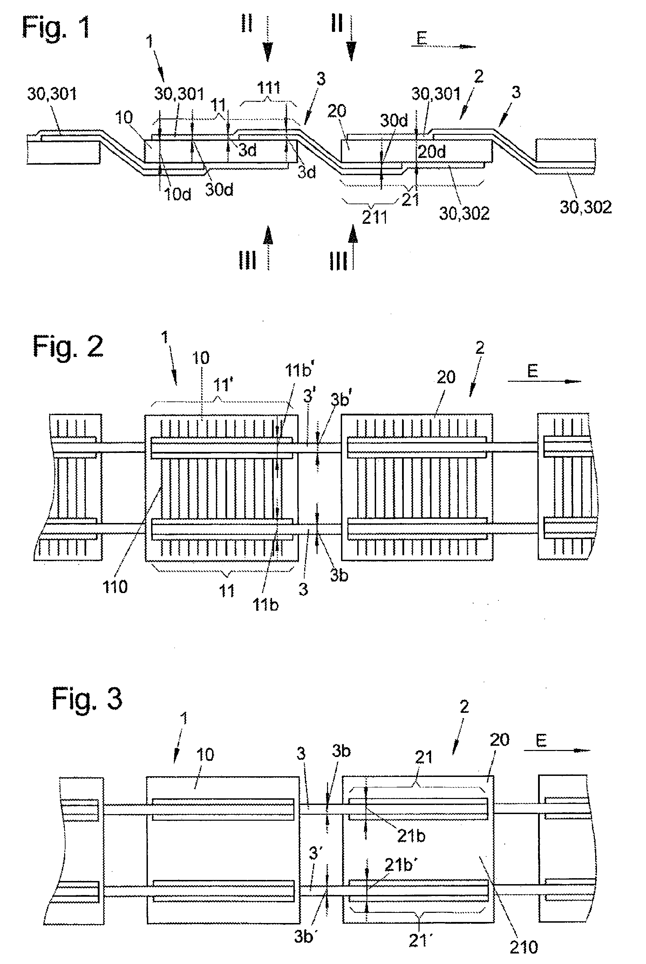

Figur 1 zeigt eine nicht maßstabsgetreue Darstellung eines Solarzellenstrings aufgebaut aus frontseitenkontaktierten Solarzellen 1,2, die aus Wafersubstraten 10,20 mit Substratdicken 10d,20d hergestellt sind. In der Seitendarstellung der Figur 1 nicht erkennbare Front-Elektroden der Solarzelle 1 und Rück-Elektroden der benachbart angeordneten weiteren Solarzelle 2 sind mittels bandförmiger Zellverbinder 3 elektrisch miteinander verschaltet. Die bandförmigen Zellverbinder 3 erstrecken sich dabei im Wesentlichen entlang einer Erstreckungsrichtung E, die auch der Erstreckungsrichtung des Solarzellenstrings entspricht. Jeder Zellverbinder 3 ist über einen Elektroden-Kontaktabschnitt 11 mit Elektroden der Solarzelle 1 und über einen weiteren Elektroden-Kontaktabschnitt 21 mit weiteren Elektroden der weiteren Solarzelle 2 kontaktiert. Die Zellverbinder 3 sind aus bandförmigen Verbinderelementen 30 aufgebaut, die entlang der Erstreckungsrichtung E des Zellverbinders 3 betrachtet versetzt angeordnet sind und somit abschnittsweise überlappen. Dieser Überlapp liegt auf der Vorderseite der Solarzelle 1 im Überlappabschnitt 111 und auf der Rückseite der weiteren Solarzelle 2 im weiteren Überlappabschnitt 211 vor.

Die Verbinderelemente 30 weisen jeweils identische Dicken 30d auf. Folglich entspricht die Dicke 3d des Zellverbinders 3 außerhalb der Überlappabschnitte 111,211 der Dicke 30d eines einzigen bandförmigen Verbinderelementes 30. In den Überlappabschnitten 111,211 beträgt die Dicke 3d des Zellverbinders 3 der doppelten Dicke 30d eines Verbinderelementes 30. Folglich nimmt die Dicke 3d des Zellverbinders 3 in Erstreckungsrichtung E betrachtet abschnittsweise zu. Die Solarzellen 1,2 sind derart angeordnet, dass der Fluss des Solarzellenstroms in Richtung der angezeigten Erstreckungsrichtung E erfolgt. Dadurch ist zum einen sicher gestellt, dass dem entlang der Erstreckungsrichtung E anwachsenden Solarzellenstrom eine gesteigerte Leiterquerschnittsfläche des Zellverbinders 3 zur Verfügung steht. Zum anderen ist auf Grund der geringeren Wärmekapazität des Zellverbinders 3 für das Verlöten des Zellverbinders 3 weniger Heizenergie-Einwirkung erforderlich, was zu einer geringeren thermischen Ausdehnung der benachbarten Bereiche der Wafersubstrate 10,20 führt. Folglich treten nach dem Lötvorgang zwischen dem Zellverbinder 3 und dem Wafersubstrat 10,20 geringere mechanische Spannungen auf. Bessere elektrische Leitfähigkeit und geringere mechanische Spannungen führen zu einem besseren Wirkungsgrad der Solarzellen nach ihrer Verschaltung in einem Solarzellenstring.

Die Zunahme der Dicke erfolgt bei dem hier gezeigten Ausführungsbeispiel sprunghaft vom Niveau der Dicke 30d eines Verbinderelementes 30 auf den doppelten Wert. Der gewünschte Effekt wäre in ähnlicher Weise mittels eines stetigen Anstiegs der Zellverbinderdicke erzielbar. Dieser stetige Anstieg könnte über die gesamte Länge des Zellverbinders 3 oder aber auch abschnittsweise erfolgen.

Es wird ausdrücklich darauf hingewiesen, dass die in Figur 1 gezeigten Abmessungen des Solarzellenstrings senkrecht zur Erstreckungsrichtung E stark vergrößert und entlang der Erstreckungsrichtung E verkleinert darstellt sind. Die Substratdicken 10d,20d betragen bevorzugt weniger als 500 µm. Üblich sind zum Beispiel Wafer mit 300 µm oder 150 µm Dicke gegenüber Wafer-Kantenlängen (Länge x Breite) von jeweils vielen Zentimetern. Entsprechend sind die bandförmigen Zellverbinder 3 bzw. die bandförmigen Verbinderelemente 30 viele Zentimeter lang bei Dicken 30d, die jeweils kleiner oder gleich den vorangehend genannten Substratdicken 10d,20d sind. Es ist klar, dass ein Solarzellenstring mindestens zwei miteinander verschaltete Solarzellen 1,2 umfasst. Diese Art der Verschaltung kann sich - wie in Figur 1 angedeutet - entlang der Erstreckungsrichtung E oftmals wiederholen.

Figur 2 zeigt eine Aufsicht auf den Solarzellenstring aus Figur 1 entlang der in Figur 1 mit II bezeichneten Pfeilrichtung. Schematisch und nicht maßstabsgetreu sind die Lichteintrittsseiten der Solarzellen 1,2 mit ihren Frontelektroden 110 zu erkennen. Die Elektroden-Kontaktabschnitte 11,11' sind als zwei Busbars ausgebildet. Bei Solarzellen mit zwei Busbars 11,11' auf der Frontseite weisen diese üblicherweise Busbar-Breiten 11 b, 11 b' von zirka 2 mm auf. Bei einem Design mit bei drei Busbars fällt die Busbar-Breite mit zirka 1,5 mm kleiner aus. Wie hier dargestellt ist die Zellverbinderbreite 3b,3b' bevorzugt kleiner als die Busbar-Breite 11 b, 11 b'. Dadurch ist auch unter Berücksichtigung von Montagetoleranzen sicher gestellt, dass die Zellverbinder keine den Busbars 11,11' benachbarten Bereiche der photoaktiven Fläche der Solarzelle 1 abschatten, was zu einer unerwünschten Herabsetzung des Wirkungsgrads führte.

Figur 3 zeigt eine Sicht auf den Solarzellenstring aus Figur 1 entlang der in Figur 1 mit III bezeichneten Pfeilrichtung. Schematisch und nicht maßstabsgetreu sind die Rückseiten der Solarzellen 1,2 zu erkennen. Die Zellverbinder 3,3' kontaktieren ebenfalls als Busbars ausgebildete weitere Elektroden-Kontaktabschnitte 21,21' für die weitere Elektrode 210, wie hier als Beispiel in Form einer flächigen Rückelektrode der Solarzelle 2 dargestellt. Dieser Aufbau wiederholt sich innerhalb des Solarzellenstrings üblicherweise bei jeder der verschalteten Solarzellen.

### Bezugszeichenliste:

- 1: Solarzelle
- 10: Wafersubstrat der Solarzelle
- 10d: Substratdicke
- 11, 11': Elektroden-Kontaktabschnitt - Busbar
- 11b, 11b': Busbar-Breite
- 110: Elektroden der Solarzelle
- 111: Überlappabschnitt auf Solarzelle
- 2: weitere Solarzelle
- 20: weiteres Wafersubstrat der weiteren Solarzelle
- 20d: Substratdicke
- 21,21': weiterer Elektroden-Kontaktabschnitt - Busbar
- 21b, 21b': Busbar-Breite
- 210: weitere Elektroden der weiteren Solarzelle
- 211: weiterer Überlappabschnitt auf weiterer Solarzelle
- 3,3': bandförmiger Zellverbinder
- 3b,3b': Zellverbinderbreite
- 3d: Zellverbinderdicke
- 30: bandförmige Verbinderelemente
- 30d: Dicke der Verbinderelemente
- 301: oberes bandförmiges Verbinderelement
- 302: unteres bandförmiges Verbinderelement

- E: Erstreckungsrichtung des Zellverbinders

## Patentansprüche

1. Solarzellenstring umfassend:
- eine Solarzelle (1), gebildet aus einem Wafersubstrat (10) mit einem flächigen Elektroden-Kontaktabschnitt (11),
- eine benachbart zur Solarzelle (1) angeordnete weitere Solarzelle (2), gebildet aus einem weiteren Wafersubstrat (20) mit einem flächigen weiteren Elektroden-Kontaktabschnitt (21) und
- mindestens einen sich entlang einer Erstreckungsrichtung (E) vom Elektroden-Kontaktabschnitt (11) der Solarzelle (1) zum weiteren Elektroden-Kontaktabschnitt (21) der weiteren Solarzelle (2) erstreckenden bandförmigen Zellverbinder (3) mit einer Zellverbinderbreite (3b) und einer im Wesentlichen senkrecht zu den Elektroden-Kontaktabschnitten (11,21) orientierten Zellverbinderdicke (3d), wobei der Zellverbinder (3) Elektroden (110) der Solarzelle (1) mit weiteren Elektroden (210) der weiteren Solarzelle (2) elektrisch miteinander verschaltet,
wobei die Zellverbinderdicke (3d) des bandförmigen Zellverbinders (3) entlang seiner Erstreckungsrichtung (E) ausgehend von der Solarzelle (1) in Richtung der weiteren Solarzelle (2) betrachtet zumindest abschnittsweise zunimmt,
die Solarzellen (1,2) als frontseitenkontaktierte Solarzellen mit Lichteintrittsseiten ausgebildet sind, wobei die Lichteintrittsseiten eine Mehrzahl Elektroden-Kontaktabschnitte (11,11',21,21') in Form von Busbars aufweist, die jeweils mit einem bandförmigen Zellverbinder (3,3') versehen sind, wobei die Zellverbinder des Solarzellenstrings von den Fromleiten der Solarzellen zu den Rückseiten der benachbarten Solarzellen verlaufen, **dadurch gekennzeichnet, dass**
der bandförmige Zellverbinder (3) in Richtung der Zellverbinderdicke (3d) betrachtet eine Mehrzahl übereinander angeordneter bandförmiger Verbinderelemente (30) umfasst, die sich entlang der Erstreckungsrichtung (E) auf einem Überlappabschnitt (111) der Solarzelle (1) und entlang eines weiteren Überlappabschnitts (211) der weiteren Solarzelle (2) abschnittsweise überlagern, und dass
in der Aufsicht auf die Lichteintrittsseiten der Solarzelle (1) die Mehrzahl der bandförmigen Verbinderelemente (30) ein in Richtung der weiteren Solarzelle (2) versetzt angeordnetes unteres bandförmiges Verbinderelement (302) aufweist, das unter einem entlang des Elektroden-Kontaktabschnittes (11) der Solarzelle (1) angeordneten oberen Verbinderelement (301) angeordnet ist.

2. Solarzellenstring gemäß Anspruch 1, **dadurch gekennzeichnet, dass** die Zellverbinderdicke (3d) in Stromflussrichtung zunimmt.

3. Solarzellenstring gemäß Anspruch 1 oder 2, **dadurch gekennzeichnet, dass** die Zellverbinderdicke (3d) des bandförmigen Zellverbinders (3) um einen Faktor von 1,5 bis 3, bevorzugt um einen Faktor 2 zunimmt.

4. Solarzellenstring gemäß einem der Ansprüche 1 bis 3, **dadurch gekennzeichnet, dass** der Elektroden-Kontaktabschnitt (11) und / oder der weitere Elektroden-Kontaktabschnitt (21) als Busbar mit einer Busbar-Breite (11b,21b) ausgebildet sind.

5. Solarzellenstring gemäß Anspruch 4, **dadurch gekennzeichnet, dass** die Zellverbinderbreite (3b) des Zellverbinders (3) im Wesentlichen kleiner oder gleich der Busbar-Breite (11b,21b) ausgebildet ist.

6. Solarzellenstring gemäß Anspruch 5, **dadurch gekennzeichnet, dass** der bandförmige Zellverbinder (3) derart auf den Busbars (11,21) angeordnet ist, dass der Zellverbinder (3) ausschließlich mit den Busbars (11,21) der Solarzellen (1,2) überlappt.

7. Solarzellenstring gemäß einem der vorangehenden Ansprüche, **dadurch gekennzeichnet, dass** die bandförmigen Verbinderelemente (30) jeweils eine Dicke aufweisen, die kleiner oder gleich der Wafersubstrat-Dicke (10d) ist.

8. Solarzellenstring gemäß einem der vorangehenden Ansprüche, **dadurch gekennzeichnet, dass** der Überlappabschnitt (111) und der weitere Überlappabschnitt (211) benachbart zueinander auf den Solarzellen (1,2) angeordnet sind und jeweils 10 bis 80%, bevorzugt 25 bis 35% der Erstreckungslänge der jeweiligen Elektroden-Kontaktabschnitte (11,21) einnehmen.

9. Solarmodul mit einer Mehrzahl miteinander verschalteter Solarzellenstrings gemäß einem der vorangehenden Ansprüche.

## Claims

1. A solar cell string comprising:
- a solar cell (1) formed from a wafer substrate (10) having an area-measured electrode contact section (11),
- a further solar cell (2) arranged adjacent to the solar cell (1) and formed from a further wafer substrate (20) having a further area-measured electrode contact section (21), and
- at least one ribbon-shaped cell connector (3) extending along an extension direction (E) from the electrode contact section (11) of the solar cell (1) to the further electrode contact section (21) of the further solar cell (2) and having a cell connector width (3b) and a cell connector thickness (3d) oriented in a substantially vertical manner to the electrode contact sections (11, 21), wherein the cell connector (3) connects electrically electrodes (110) of the solar cell (1) to further electrodes (210) of the further solar cell (2),
wherein the cell connector thickness (3d) of the ribbon-shaped cell connector (3) increases at least in sections considered along its extension direction (E) from the solar cell (1) in the direction to the further solar cell (2),
the solar cells (1,2) are formed as front side contacted solar cells having light entrance faces, wherein the light entrance faces have a plurality of electrode contact sections (11,11',21,21') in the form of busbars each provided with a ribbon-shaped cell connector (3,3'), wherein the cell connectors of the solar cell string run from the front sides of the solar cells to the rear sides of the neighboring solar cells, **characterized in that** the ribbon-shaped cell connector (3) comprises considered in the direction of the cell connector thickness (3d) a plurality of ribbon-shaped connector elements (30) arranged one above the other and overlapping in sections along the extension direction (E) in an overlap section (111) of the solar cell (1) and along a further overlap section (211) of the further solar cell (2), and that
in view on the light entrance faces of the solar cell (1) the plurality of the ribbon-shaped connector elements (30) has a lower ribbon-shaped connector element (302) arranged in staggered manner in direction of the further solar cell (2) and arranged below an upper contact element (301) arranged along the electrode contact section (11) of the solar cell (1).

2. The solar cell string according to claim 1, **characterized in that** the cell connector thickness (3d) increases in a current flow direction.

3. The solar cell string according to claim 1 or 2, **characterized in that** the cell connector thickness (3d) of the ribbon-shaped cell connector (3) increases about a factor of 1.5 to 3, preferably about a factor of 2.

4. The solar cell string according to one of the claims 1 to 3, **characterized in that** the electrode contact section (11) and / or the further electrode contact section (21) is formed as busbar having a busbar thickness (11b,21b).

5. The solar cell string according to claim 4, **characterized in that** die the cell connector thickness (3b) of the cell connector (3) is formed substantially smaller than or equal to the busbar width (11 b,21 b).

6. The solar cell string according to claim 5, **characterized in that** the ribbon-shaped cell connector (3) is arranged on the busbars (11,21) in such a manner that the cell connector (3) overlaps exclusively with the busbars (11,21) of the solar cells (1,2).

7. The solar cell string according to one of the preceding claims, **characterized in that** the ribbon-shaped connector elements (30) each have a thickness being smaller than or equal to the wafer substrate thickness (10d).

8. The solar cell string according to one of the preceding claims, **characterized in that** the overlap section (111) and the further overlap section (211) are arranged adjacent to each other on the solar cells (1,2) and take respectively 10 to 80%, preferably 25 to 35% of the extension length of the respective electrode contact sections (11,21).

9. A solar module having a plurality of solar cell strings according to one of the preceding claims connected to each other.

## Revendications

1. Un string de cellules solaires comprenant:
- une cellule solaire (1) formée d'un substrat en plaquette (10) avec une partie de contact d'électrode étendue (11),
- une cellule solaire (2) arrangée de manière avoisinante à la cellule solaire (1) et formée d'un autre substrat en plaquette (20) avec une autre partie de contact d'électrode étendue (21) et
- au moins un connecteur de la cellule (3) en forme de bande qui s'étende le long d'une direction d'extension (E) de la partie de contact d'électrode (11) de la cellule solaire (1) vers l'autre partie de contact d'électrode (21) de l'autre cellule solaire (2) et a une largeur du connecteur de la cellule (3b) et une épaisseur du connecteur de la cellule (3d) orientée essentiellement verticale aux parties de contact d'électrode (11,21), lequel connecteur de la cellule (3) connecte des électrodes (110) de la cellule solaire (1) avec des autres électrodes (210) de l'autre cellule solaire (2) électriquement les unes aux autres,
laquelle épaisseur du connecteur de la cellule (3d) du connecteur de la cellule (3) en forme de bande augmente au moins par passage considérée le long de sa direction d'extension (E) à partir de la cellule solaire (1) en direction de l'autre cellule solaire (2),
lesquelles cellules solaires (1,2) sont formées en cellules solaires contactées à la face avant et avec des côtés d'entrée de lumière, lesquels côtés d'entrée de lumière ont une pluralité de parties de contact d'électrode (11,11',21,21') en forme de barres-bus pourvues respectivement d'un connecteur de la cellule (3,3') en forme de bande, lesquels connecteurs de la cellule du string de cellules solaires passent des faces avant des cellules solaires aux faces arrière des cellules solaires avoisinantes, **caractérisé en ce que**
le connecteur de la cellule (3) en forme de bande comprend considéré en direction de l'épaisseur du connecteur de la cellule (3d) un pluralité d'éléments de connecteur (30) en forme de bande et arrangés les uns sur les autres, lesquels se superposent en passages le long de la direction d'extension (E) sur une partie de chevauchement (111) de la cellule solaire (1) et le long d'une autre partie de chevauchement (211) de l'autre cellule solaire (2), et que
en vue de dessus sur les côtés d'entrée de lumière de la cellule solaire (1) la pluralité des éléments de connecteur (30) en forme de bande a un élément de connecteur (302) en forme de bande et inférieur et disposé de manière décalée en direction de l'autre cellule solaire (2), lequel est disposé sous un élément de connecteur (301) supérieur et disposé le long de la partie de contact d'électrode (11) de la cellule solaire (1).

2. Le string de cellules solaires selon la revendication 1, **caractérisé en ce que** l'épaisseur de connecteur de la cellule (3d) augmente en direction du flux du courant.

3. Le string de cellules solaires selon la revendication 1 ou 2, **caractérisé en ce que** l'épaisseur du connecteur de la cellule (3d) du connecteur de la cellule (3) en forme de bande augmente d'un facteur 1,5 à 3, préférentiellement d'un facteur 2.

4. Le string de cellules solaires selon une des revendications 1 à 3, **caractérisé en ce que** la partie de contact d'électrode (11) et / ou l'autre partie de contact d'électrode (21) est formée en barre-bus avec une largeur de barre-bus (11b,21b).

5. Le string de cellules solaires selon la revendication 4, **caractérisé en ce que** la largeur de connecteur de la cellule (3b) du connecteur de la cellule (3) est formée essentiellement plus petite ou égale à la largeur de barre-bus (11b,21b).

6. Le string de cellules solaires selon la revendication 5, **caractérisé en ce que** le connecteur de la cellule (3) en forme de bande est disposé sur les barres-bus (11,21) de sorte que le connecteur de la cellule (3) enchevauche exclusivement les barres-bus (11,21) des cellules solaires (1,2).

7. Le string de cellules solaires selon une des revendications précédentes, **caractérisé en ce que** les éléments de connecteur (30) en forme de bande ont respectivement une épaisseur qui est plus petite ou égale à l'épaisseur du substrat en plaquette (10d).

8. Le string de cellules solaires selon une des revendications précédentes, **caractérisé en ce que** la partie de chevauchement (111) et l'autre partie de chevauchement (211) sont disposées avoisinante l'une à l'autre sur les cellules solaires (1,2) et occupent respectivement 10 à 80%, préférentiellement 25 à 35% de la longueur d'extension des parties de contact d'électrode (11,21) respectives.

9. Un panneau solaire avec une pluralité de strings de cellules solaires selon une des revendications précédentes connectés les uns aux autres.
